(19) **Europäisches Patentamt European Patent Office Office européen des brevets**

(11) **EP 3 296 376 B1**

(12) **EUROPEAN PATENT SPECIFICATION**

(45) Date of publication and mention of the grant of the patent:
**05.07.2023 Bulletin 2023/27**

(51) International Patent Classification (IPC):
*C09K 3/14 (2006.01)*     *B24B 37/00 (2012.01)*
*H01L 21/304 (2006.01)*

(21) Application number: **16792613.8**

(22) Date of filing: **02.05.2016**

(52) Cooperative Patent Classification (CPC):
B24B 57/02; **C09G 1/02; C09K 3/1463;**
**H01L 21/02021;** B24B 37/08; C09K 3/1409

(86) International application number:
**PCT/JP2016/063597**

(87) International publication number:
**WO 2016/181888 (17.11.2016 Gazette 2016/46)**

(54) **METHOD OF POLISHING**

POLIERVERFAHREN

PROCÉDÉ DE POLISSAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.05.2015 JP 2015095635**

(43) Date of publication of application:
**21.03.2018 Bulletin 2018/12**

(73) Proprietor: **Fujimi Incorporated**
**Kiyosu-shi, Aichi 452-8502 (JP)**

(72) Inventors:
• **ODA Hiroyuki**
**Kiyosu-shi, Aichi 452-8502 (JP)**
• **TAKAHASHI Shuhei**
**Kiyosu-shi, Aichi 452-8502 (JP)**
• **MORI Yoshio**
**Kiyosu-shi, Aichi 452-8502 (JP)**
• **TAKAMI Shinichiro**
**Kiyosu-shi, Aichi 452-8502 (JP)**
• **TABATA Makoto**
**Kiyosu-shi, Aichi 452-8502 (JP)**

(74) Representative: **Grünecker Patent- und Rechtsanwälte**
**PartG mbB**
**Leopoldstraße 4**
**80802 München (DE)**

(56) References cited:
WO-A1-2010/122985    JP-A- 2008 053 415
KR-A- 20050 050 351    KR-A- 20060 019 257
US-A1- 2014 263 184    US-A1- 2015 060 400
US-B1- 6 409 581

## Description

Technical Field

The present invention relates to a method of double side polishing an object, as defined by the preamble of claim 1 and as for example known from US2015/060400 A1.

Background Art

Fine polishing using a polishing liquid is performed to the surface of materials, such as metals, metalloids, nonmetals, and oxides thereof. For example, the surface of a silicon wafer used as a constituent component of semiconductor products or the like is generally finished to a high-quality mirror surface through a lapping step (rough polishing step) and a polishing step (fine polishing step). The polishing step typically includes a stock polishing step and a final polishing step. Patent Literatures 1 to 3 are mentioned as technical literatures on polishing compositions mainly used for polishing semiconductor substrates, such as a silicon wafer. Patent Literature 4 relates to a polishing liquid for a CMP process.

Citation List

Patent Literatures

PTL 1: JP 2005-268667 A
PTL 2: WO 2012/63757
PTL 3: JP 2014-041978 A
PTL 4: WO 2004/100242

Summary of Invention

Technical Problem

In recent years, with respect to semiconductor substrates, such as a silicon wafer, and other substrates, the area has increased due to an increase in the diameter, and therefore an improvement of the global flatness of the substrates has been desired. Under such circumstances, there has been a problem that, when polishing is performed using former conventional polishing compositions, a desired global flatness has not been obtained.

Solution to Problem

The present invention has been made in view of the above-described circumstances. It is an object of the present invention to provide a polishing composition obtaining a good global flatness.
The present invention provides a method as defined in claim 1. Further embodiments are defined in the dependent claims.

Brief Description of Drawings

FIG. 1 is a perspective view illustrating a single-side polishing machine according to one embodiment of the present invention; and
FIG. 2 is perspective view illustrating a double-side polishing machine according to one embodiment of the present invention.

Description of Embodiments

Preferred embodiments of the present invention are described below. Matters necessary to implement this invention other than those specifically referred to in this description may be understood as design matters of a person skilled in the art based on the conventional techniques in the pertinent field. The present invention can be implemented based on the contents disclosed in this description and common technical knowledge in the subject field.

<Fitting of polishing composition>

The fitting of a polishing composition to a part shows the degree of adhesion that the polishing composition stays on the part without being rejected. A method for evaluating the fitting is not particularly limited insofar as the method can quantitatively evaluate the property that the polishing composition stays on the part without being rejected. For example, the evaluation can be performed by measuring the contact angle, the dynamic surface tension, the circularity, the wet area, and the like . A method for measuring the contact angle is not particularly limited. Examples of the method include observing a static contact angle when a liquid droplet is dropped to the surface of the part disposed horizontally to the ground, an advancing contact angle which is the contact angle in a movement direction of a liquid droplet when the liquid droplet is slid by inclining a part on which the liquid droplet is placed, a receding contact angle which is the contact angle in a direction opposite to the movement direction of the liquid droplet, and the like. The receding contact angle is preferable in a respect of satisfactorily showing the fitting of a polishing composition to a part in actual dynamic polishing. A method for measuring the dynamic surface tension is not particularly limited. Examples of the method include a Wilhelmy method, a ring method, a pendant drop method, a maximum bubble pressure method, and the like. The Wilhelmy method is preferable in a respect of satisfactorily showing the fitting of a polishing composition to a part in actual dynamic polishing.

The mechanism that the global flatness, of the entire substrate surface can be improved by the polishing composition satisfying either Formula (I) or Formula (II) above is considered as follows. More specifically, in order to improve the global flatness of the object to be polished, the polishing composition needs to uniformly spread from a peripheral portion to the central portion of the object to be polished. Formula (I) shows that the fitting of the polishing composition to the polishing pad is equal to or higher than the fitting thereof to a holding tool of the object to be polished. More specifically, Formula (I) shows that the fitting of the polishing composition to the polishing pad is higher. Since the polishing pad has higher linear velocity and higher kinetic energy than those of the object to be polished and the holding tool of the object to be polished, the polishing composition spreads to the entire object to be polished. Therefore, the global flatness of the object to be polished improves.

Formula (II) shows that the fitting of the polishing composition to an object to be polished is the highest and the fitting thereof to a holding tool of the object to be polished and the fitting thereof to a polishing pad decreases in this order. In this case, the fitting of the polishing composition to a polishing pad is low, and therefore, the polishing composition does not spread to the entire object to be polished depending on the movement of the polishing pad but the fitting thereof to an object to be polished is the highest and the fitting to the holding tool of an object to be polished is the second highest, and therefore the polishing composition spreads from the peripheral portion to the central portion of the object to be polished by the rotational movement of the polishing. Therefore, the global flatness of the object to be polished improves.

With respect to the receding contact angle, a larger value shows that the fitting to a part is lower and a smaller value shows that the fitting to a part is higher. More specifically, Formula (III) shows that the fitting of the polishing composition to a polishing pad is equal to or higher than the fitting thereof to a holding tool of an object to be polished, and the global flatness of the object to be polished improves by the same mechanism as that of Formula (I) . Formula (IV) shows that the fitting of the polishing composition to an object to be polished is the highest and the fitting thereof to a holding tool of an object to be polished and the fitting thereof to a polishing pad decreases in this order, and the global flatness of the object to be polished improves by the same mechanism as that of Formula (II) .

With respect to the dynamic surface tension, a larger value shows that the fitting to a part is higher and a smaller value shows that the fitting to a part is lower. More specifically, Formula (V) shows that the fitting of the polishing composition to a polishing pad is equal to or higher than the fitting to a holding tool of an object to be polished, and the global flatness of the object to be polished improves by the same mechanism as that of Formula (I) . Formula (VI) shows that the fitting of the polishing composition to an object to be polished is the highest and the fitting thereof to a holding tool of an object to be polished and the fitting thereof to a polishing pad decreases in this order, and the global flatness of the object to be polished improves by the same mechanism as that of Formula (II).

In order for the values of the Wp, Wc, Ww, Cc, Cp, Cw, Tp, Tc, and Tw which are indexes showing the fitting of the polishing composition to satisfy Formulae (I) to (VI) above, it can be achieved by selecting appropriate combinations of components of the polishing composition, materials and roughness of a polishing pad, the composition of an object to be polished, and materials and roughness of a holding tool of an object to be polished. As the components in the polishing composition, the content of particularly a water-soluble polymer and the like has an influence thereon in many cases.

With respect to the receding contact angle, the receding contact angle Cp to a polishing pad is preferably 90° or less and more preferably 80° or less. Although not particularly limited, the Cp is preferably 1° or more, more preferably 5° or more, and still more preferably 10° or more. Due to the fact that the Cp is within the ranges mentioned above, the global flatness of a substrate further improves. The receding contact angle $C_p$ to a polishing pad is controllable by selecting combinations of components of the polishing composition and materials of the polishing pad as appropriate.

The receding contact angle $C_w$ to an object to be polished is preferably 70° or less, more preferably 60° or less, and still more preferably 50° or less. Although not particularly limited, the $C_w$ is preferably 1° or more, more preferably 5° or more, and still more preferably 10° or more. Due to the fact that $C_w$ is within the ranges mentioned above, the global flatness of a substrate further improves. The receding contact angle $C_w$ to an object to be polished is controllable by selecting combinations of components of the object to be polished and materials of the polishing pad as appropriate.

The receding contact angle $C_c$ to a holding tool of an object to be polished is preferably 70° or less, more preferably 60° or less, and still more preferably 50° or less. Although not particularly limited, the $C_c$ is preferably 1° or more, more preferably 5° or more, and still more preferably 10° or more. Due to the fact that the $C_w$ is within the ranges mentioned above, the global flatness of a substrate further improves. The receding contact angle $C_c$ to a holding tool of an object to be polished is controllable by selecting combinations of components of the polishing composition and materials of the holding tool of an object to be polished as appropriate.

The receding contact angle $C_p$ of the polishing composition to a polishing pad can be measured based on the following procedure, for example.

(1P) Dispose a new polishing pad on a dynamic contact angle meter DM-501 manufactured by Kyowa Interface Science Co., LTD.
(2P) Drop 30 μL of the polishing composition to the polishing pad.
(3P) Incline the polishing pad at a rate of 1°/s after dropping the polishing composition, and then measure the receding contact angle after the lapse of 10 seconds.

The receding contact angle $C_w$ of the polishing composition to an object to be polished can be measured based on the following procedure, for example.

(1W) Dispose an object to be polished which has been mirror-finished and from which a native oxide layer has been removed beforehand on a dynamic contact angle meter DM-501 manufactured by Kyowa Interface Science Co., LTD.
(2W) Drop 30 μL of the polishing composition to the object to be polished.
(3W) Incline the object to be polished at a rate of 1°/s after dropping the polishing composition, and then measure the receding contact angle after the lapse of 10 seconds.

The receding contact angle $C_c$ to a holding tool of an object to be polished of the polishing composition can be measured based on the following procedure, for example.

(1C) Dispose a new holding tool of an object to be polished on a dynamic contact angle meter DM-501 manufactured by Kyowa Interface Science Co., LTD.
(2C) Drop 30 μL of the polishing composition to the holding tool of an object to be polished.
(3C) Incline the holding tool of an object to be polished at a rate of 1°/s after dropping the polishing composition, and then measure the receding contact angle after the lapse of 10 seconds.

With respect to the dynamic surface tension of the polishing composition, the dynamic surface tension $T_p$ to a polishing pad is preferably 0.1 mN or more, more preferably 1.0 mN or more, and still more preferably 3.0 mN or more. Although not particularly limited, the $T_p$ is preferably 10.0 mN or less, more preferably 6.0 mN or less, and still more preferably 5.0 mN or less. Due to the fact that $T_p$ is within the ranges mentioned above, the global flatness of a substrate further improves. The dynamic surface tension $T_p$ to a polishing pad is controllable by selecting combinations of components of the polishing composition and materials of the polishing pad as appropriate.

The dynamic surface tension $T_w$ to an object to be polished is preferably 0.5 mN or more, more preferably 1.0 mN or more, and still more preferably 2.0 mN or more. Although not particularly limited, the $T_w$ is preferably 10.0 mN or less, more preferably 6.0 mN or less, and still more preferably 4.0 mN or less. Due to the fact that the $T_w$ is within the ranges mentioned above, the global flatness of a substrate further improves. The dynamic surface tension $T_w$ to an object to be polished is controllable by selecting combinations of the composition of the polishing composition and materials of the object to be polished as appropriate.

The dynamic surface tension $T_c$ to a holding tool of an object to be polished is preferably 0.1 mN or more, more preferably 0.5 mN or more, and still more preferably 1.0 mN or more. Although not particularly limited, the $T_c$ is preferably 10.0 mN or less, more preferably 5.0 mN or less, and still more preferably 3.0 mN or less. Due to the fact that the $T_w$ is within the ranges mentioned above, the global flatness of a substrate further improves. The dynamic surface tension $T_c$ to a holding tool of an object to be polished is controllable by selecting combinations of the composition of the polishing composition and materials of the holding tool of an object to be polished as appropriate.

A ratio Tw/Tc of the dynamic surface tension Tw to a object to be polished to the dynamic surface tension Tc to a holding tool of an object to be polished is preferably 1.0 or more, more preferably 1.2 or more, and still more preferably 1.5 or more. Although not particularly limited, the Tw/Tc is preferably 3.0 or less, more preferably 2.8 or less, and still more preferably 2.6 or less. Due to the fact that the Tw/Tc is within the ranges mentioned above, the global flatness of a substrate further improves.

The dynamic surface tension Tp of the polishing composition to a polishing pad can be measured based on the following procedure, for example.

(1p) Cut a new polishing pad into a size of 25 mm $\times$ 40 mm.

(2p) Take out the polishing pad, and then immerse the same in the polishing composition for 1 minute.

(3p) Take out the polishing pad, and then immerse the same in a container containing ion exchanged water for 1 second.

(4p) Take out the polishing pad, and then spray air thereto until excess water is blown off with an air gun or the like.

(5p) Dispose the polishing pad on a dynamic wettability tester 6200TN manufactured by Rhesca Co., Ltd.

(6p) Immerse the polishing pad in the polishing composition disposed in the dynamic wettability tester beforehand up to 10mm depth at a rate of 0.2 mm/s, and then hold the same for 2 seconds.

(7p) Pull up the polishing pad at a rate of 0.2 mm/s.

(8p) Measure the advancing surface tension by the above-described test.

The dynamic surface tension Tw of the polishing composition to an object to be polished can be measured based on the following procedure, for example.

(1w) Cut a new object to be polished into a size of 25 mm $\times$ 40 mm.

(2w) Immerse the object to be polished in a chemical solution of ammonia:hydrogen peroxide:ion exchanged water = 1:1:30 (volume ratio) for 60 seconds.

(3w) Take out the object to be polished, and then immerse the object to be polished in 5% hydrofluoric acid for 60 seconds.

(4w) Take out the object to be polished, and then immerse the same in the polishing composition for 1 minute.

(5w) Take out the object to be polished, and then immerse the same in a container containing ion exchanged water for 1 second.

(6w) Take out the object to be polished, and then spray air thereto until excess water is blown off with an air gun or the like.

(7w) Dispose the object to be polished in a dynamic wettability tester 6200TN manufactured by Rhesca Co., Ltd.

(8w) Immerse 10 mm of the object to be polished in the polishing composition disposed in the dynamic wettability tester beforehand at a rate of 0.2 mm/s, and then hold the same for 2 seconds.

(9w) Pull up the object to be polished at a rate of 0.2 mm/s.

(10w) Measure the advancing surface tension by the above-described test.

The dynamic surface tension Tc of the polishing composition to a holding tool of an object to be polished can be measured based on the following procedure, for example.

(1c) Cut a new holding tool of an object to be polished into a size of 25 mm $\times$ 40 mm.

(2c) Immerse the holding tool of an object to be polished in a chemical solution of ammonia:hydrogen peroxide:ion exchanged water = 1:1:30 (volume ratio) for 60 seconds.

(3c) Take out the holding tool of an object to be polished, and then immerse the object to be polished in 5% hydrofluoric acid for 60 seconds.

(4c) Take out the holding tool of an object to be polished, and then immerse the same in the polishing composition for 1 minute.

(5c) Take out the holding tool of an object to be polished, and then immerse the same in a container containing ion exchanged water for 1 second.

(6c) Take out the holding tool of an object to be polished, and then spray air thereto until excess water is blown off with an air gun or the like.

(7c) Dispose the holding tool of an object to be polished in a dynamic wettability tester 6200TN manufactured by Rhesca Co., Ltd.

(8c) Immerse 10 mm of the holding tool of an object to be polished in the polishing composition disposed in the dynamic wettability tester beforehand at a rate of 0.2 mm/s, and then hold the same for 2 seconds.

(9c) Pull up the holding tool of an object to be polished at a rate of 0.2 mm/s.

(10c) Measure the advancing surface tension by the above-described test.

<Abrasives>

The polishing composition disclosed herein can include abrasives. The material and the properties of the abrasives are not particularly limited and the abrasives may be suitably selected according to the purpose, the application of the polishing composition, and the like. Examples of the abrasives include inorganic particles, organic particles, and organic-inorganic composite particles. Specific examples of the inorganic particles include oxide particles (for example, silica particles, alumina particles, cerium oxide particles, chromium oxide particles, titanium dioxide particles, zirconium oxide particles, magnesium oxide particles, manganese dioxide particles, zinc oxide particles, and red iron oxide particles), nitride particles (for example, silicon nitride particles and boron nitride particles), carbide particles (for example, silicon carbide particles and boron carbide particles), diamond particles, carbonate (for example, calcium carbonate and barium carbonate), and the like. Specific examples of the organic particles include polymethyl methacrylate (PMMA) particles, poly(meth)acrylic acid particles (Herein, the (meth)acrylic acid means comprehensively including acrylic acid and methacrylic acid.), polyacrylonitrile particles, and the like. Such abrasives may be used alone or in combination of two or more species thereof.

The abrasives are preferably the inorganic particles and particularly preferably particles containing oxides of metals or metalloids. Preferable examples of the abrasives that can be used in the art disclosed herein include silica particles. For example, when the art disclosed herein is applied to a polishing composition which may be used for polishing a silicon wafer, silica particles are particularly preferably used as the abrasives. This is because, in the case where the object to be polished is a silicon wafer, when silica particles formed of the same elements as those of the object to be polished and oxygen atoms is used as the abrasives, residues of metals or metalloids different from silicon will not be generated after polishing, which eliminates possibilities of a contamination of the silicon wafer surface, a degradation of the electric properties as a silicon wafer due to a diffusion of metals or metalloids different from silicon into the object to be polished, and the like. Furthermore, the hardness of silicon and the hardness of silica are close to each other, and therefore there is also an advantage that polishing processing can be performed without excessively damaging the silicon wafer surface. An example of one aspect of the preferable polishing composition from the above-described viewpoints is a polishing composition consisting of silica particles as the abrasives. By nature, silica can be easily obtained in a highly pure state . This is also mentioned as a reason why silica particles are preferable as the abrasives. Specific examples of silica particles include colloidal silica, fumed silica, precipitated silica, and the like. From the viewpoints that scratches are less likely to be generated on the surface of the object to be polished and a surface with lower haze may be realized, colloidal silica and fumed silica are mentioned as preferable silica particles. In particular, colloidal silica is preferable.

The true specific gravity of the silica constituting the silica particles is typically 1.5 or more, usually appropriately 1.5 or more, preferably 1.7 or more, more preferably 1.8 or more, still more preferably 1.9 or more, and particularly preferably 2.0 or more. By an increase in the silica density, the polishing removal rate may improve when polishing the object to be polished (for example, silicon wafer). From the viewpoint of reducing scratches generated on the surface (surface to be polished) of the object to be polished, silica particles having the above-described density of 2.3 or less, e.g., 2.2 or less, are preferable. As the density of the abrasives (typically silica), the value measured by a liquid displacement method using ethanol as the displacement liquid may be adopted.

In the art disclosed herein, the abrasives contained in the polishing composition may be a form of primary particles or may be a form of secondary particles in which a plurality of primary particles aggregate. Alternatively, the abrasives may be present both in the form of primary particles and in the form of secondary particles. In one preferable aspect, at least some abrasives are present in the form of secondary particles in the polishing composition.

The average primary particle diameter of the abrasives is not particularly limited is preferably 20 nm or larger, more preferably 30 nm or larger, and still more preferably 40 nm or larger from the viewpoints of polishing removal efficiency and the like. From the viewpoint that a surface having high smoothness is easily obtained, the average primary particle diameter of the abrasives is preferably 150 nm or smaller, more preferably 100 nm or smaller, and still more preferably 80 nm or smaller.

In the art disclosed herein, the average primary particle diameter of the abrasives can be calculated by an expression of Average primary particle diameter (nm) = 2727/S from the specific surface area S ($m^2$/g) measured by the BET method, for example. The measurement of the specific surface area of the abrasives can be performed using a surface area meter manufactured by Micromeritics, Trade name "FlowSorb II 2300" , for example.

The average secondary particle diameter of the abrasives is not particularly limited and is preferably 30 nm or larger, more preferably 40 nm or larger, and still more preferably 50 nm or larger from the viewpoints of the polishing removal rate and the like. From the viewpoint of obtaining a surface having higher smoothness, the average secondary particle diameter of the abrasives is preferably 300 nm or smaller, more preferably 200 nm or smaller, and still more preferably 150 nm or smaller.

In the art disclosed herein, the average secondary particle diameter of the abrasives can be measured as a volume average particle diameter (Arithmetic average diameter on a volume basis; Mv) by a dynamic light scattering method using a "UPA-UT151" type manufactured by Nikkiso Co., Ltd., for example.

The average secondary particle diameter of the abrasives is generally equal to or larger than the average primary particle diameter of the abrasives and is typically larger than the average primary particle diameter. Although not particularly limited, the average secondary particle diameter of the abrasives is preferably 1.2 times or more and 3.0 times or less, more preferably 1.5 times or more and 2.5 times or less, still more preferably 1.7 times or more and 2.3 times or less, and yet still more preferably 1.9 times or more and 2.2 times or less from the viewpoints of the polishing effect and the surface smoothness after polishing.

The shape (outer shape) of the abrasives may be a spherical shape or may be a non-spherical shape. Specific examples of the abrasives having a non-spherical shape include a peanut shape (i .e., shape of the shell of a peanut), a cocoon shape, a shape with a projection, a konpeito-(pointed sugar candy ball-) like shape, a Rugby ball shape, and the like. As the abrasives, one kind of the same shape may be used alone or two or more kinds of different shapes may be used in combination. For example, abrasives mostly having a konpeito- (pointed sugar candy ball-) like shape may be preferably adopted.

Although not particularly limited, the average Major axis/Minor axis ratio (average aspect ratio) of the primary particles of the abrasives is preferably 1.05 or more and more preferably 1.1 or more. A higher polishing removal rate may be realized by an increase in the average aspect ratio of the abrasives. From the viewpoints of scratch reduction and the like, the average aspect ratio of the abrasives is preferably 3.0 or less, more preferably 2.0 or less, and still more preferably 1.5 or less.

The shape (outer shape) and the average aspect ratio of the abrasives can be assessed by electron microscope observation, for example. As a specific procedure of determining the average aspect ratio, a minimum rectangle circumscribing each particle image is drawn for a predetermined number (for example, 200 particles) of abrasive particles, the independent particle shape of which can be recognized, using a scanning electron microscope (SEM), for example. Then, a value obtained by dividing the length (value of the major axis) of the long side by the length (value of the minor axis) of the short side is calculated as the major axis/minor axis ratio (aspect ratio) for the rectangle drawn for each particle image. The average aspect ratio can be determined by obtaining the arithmetic average of the aspect ratios of the predetermined number of the particles.

The amount of the abrasives contained in the polishing composition is preferably 0.01% by weight or more, more preferably 0.05% by weight or more, and still more preferably 0.1% by weight or more. A higher polishing removal rate may be realized by an increase in the amount of the abrasives. The amount of the abrasives contained in the polishing composition is preferably 20% by weight or less, more preferably 10% by weight or less, still more preferably 5% by weight or less, and yet still more preferably 2% by weight or less from the viewpoints of the dispersion stability of the polishing composition and the like.

<Water-soluble polymer>

The polishing composition disclosed herein can include a water-soluble polymer. The water-soluble polymer has a large effect of improving the flatness of a substrate by adsorption to interface between each part and thereby change the contact angle.

Examples of the water-soluble polymer include a cellulose derivative, a starch derivative, a polymer containing an oxyalkylene unit, a polymer containing a nitrogen atom, a vinylalcohol polymer, and the like.

Examples of the cellulose derivative include hydroxymethylcellulose, hydroxyethylcellulose, hydroxypropylcellulose, carboxymethylcellulose, and the like. Among the above, hydroxyethylcellulose may be preferably adopted.

Specific examples of the starch derivative include pullulan, hydroxypropyl starch, and the like.

Examples of the polymer containing an oxyalkylene unit include polyethylene glycol, polyethylene oxide, polypropylene oxide, a random copolymer and a block copolymer of ethylene oxide and propylene oxide, and the like.

Examples of the polymer containing a nitrogen atom include pyrrolidone polymers, such as polyvinyl pyrrolidone, polyacryloyl morpholine, polyacrylamide, and the like. Among the above, polyvinyl pyrrolidone may be preferably adopted.

Examples of the vinyl alcohol polymer include polyvinyl alcohol, cation-modified polyvinyl alcohol, anion-modified polyvinyl alcohol, and the like. Among the above, polyvinyl alcohol may be preferably adopted.

Examples of other water-soluble polymers include polyisoprene sulfonic acid, polyvinyl sulfonic acid, polyallyl sulfonic acid, polyisoamylene sulfonic acid, polystyrene sulfonate salt, polyacrylate salt, polyvinyl acetate, and the like.

The water-soluble polymers may be used alone or in combination of two or more types thereof. Moreover, a homopolymer may be used and a copolymer may be used.

The amount of the water-soluble polymer contained in the polishing composition is preferably 0.000001% by weight or more, more preferably 0.00001% by weight or more, and still more preferably 0.0001% by weight or more. A flatter substrate can be obtained by an increase in the amount of the water-soluble polymer. The amount of the water-soluble polymer contained in the polishing composition is preferably 0.01% by weight or less, more preferably 0.001% by weight or less, and still more preferably 0.0005% by weight or less from the viewpoints of an increase in the polishing removal rate and the like.

<Salt>

The polishing composition disclosed herein can include a salt. As the salt, both organic acid salts and inorganic acid salts are usable. The salts may be used alone or in combination of two or more types thereof.

Examples of anionic components constituting the salts include carbonate ions, hydrogen carbonate ions, borate ions, phosphate ions, phenol ions, monocarboxylate ions (for example, formate ion, acetate ion, propionate ion, 2-hydroxybutyrate ion, and malate ion), dicarboxylate ions (for example, oxalate ion, maleate ion, malonate ion, tartrate ion, and succinate ion), tricarboxylate ions (for example, citrate ion), organic sulfonate ions, organic phosphonate ions, and the like. Examples of cationic components constituting the salt include alkali metal ions (for example, potassium ion and sodium ion) , alkaline-earth metal ions (for example, calcium ion and magnesium ion), transition metal ions (for example, manganese ion, cobalt ion, zinc ion), ammonium ions (for example, tetraalkylammonium ion) , phosphonium ions (for example, tetraalkylphosphonium ion), and the like. Specific examples of the salt include sodium carbonate, potassium carbonate, sodium hydrogen carbonate, potassium bicarbonate, sodium acetate, potassium acetate, sodium propionate, potassium propionate, calcium carbonate, hydrogen carbonate calcium, calcium acetate, calcium propionate, magnesium acetate, magnesium propionate, zinc propionate, manganese acetate, cobalt acetate, and the like. Among the above, potassium carbonate may be preferably adopted.

The amount of the salt contained in the polishing composition is preferably 0.001% by weight or more, more preferably 0.005% by weight or more, and still more preferably 0.01% by weight or more. The sustainability of performance when the polishing composition is repeatedly used may be improved by an increase in the amount of the salt. The amount of the salt contained in the polishing composition is preferably 0.5% by weight or less, more preferably 0.1% by weight or less, and still more preferably 0.05% by weight or less from the viewpoint of an improvement of the storage stability of the polishing composition.

<Basic composition>

The polishing composition disclosed herein can include a basic compound. The basic compound is a component which chemically polishes an object to be polished and contributes to an improvement of the polishing removal rate. The basic compound also has an effect of changing the contact angle by adsorption to interface between each part as with the above-described water-soluble polymer. The basic compound may be an organic basic compound or may be an inorganic basic compound. The basic compound may be used alone or in combination of two or more types thereof.

Examples of the organic basic compound include quaternary ammonium salts, such as tetraalkylammonium salt. Anions in the ammonium salt may be $OH^-$, $F^-$ , $Cl^-$ , $Br^-$, $I^-$, $ClO_4^-$, $BH_4^-$, and the like, for example. For example, quaternary ammonium salts, such as choline, tetramethylammonium hydroxide, tetraethylammonium hydroxide, tetrapropylammonium hydroxide, and tetrabutylammonium hydroxide, may be preferably used. In particular, tetramethylammonium hydroxide is preferable.

Other examples of the organic basic compound include quaternary phosphonium salts, such as tetraalkyl phosphonium salt. Anions in the phosphonium salt may be $OH^-$, $F^-$, $Cl^-$, $Br^-$, $I^-$, $ClO_4^-$, $BH_4^-$, and the like, for example. For example, halides and hydroxides of tetramethyl phosphonium, tetraethyl phosphonium, tetrapropyl phosphonium, tetrabutylphosphonium, and the like may be preferably used.

Other examples of the organic basic compound include amines (for example, methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, and triethylenetetramine) , piperazines (for example, piperazine, 1-(2-aminoethyl)piperazine, and N-methylpiperazine), azoles (for example, imidazole and triazole), diazabicycloalkanes (for example, 1,4-diazabicyclo(2.2.2)octane, 1,8-diazabicyclo[5.4.0]undeca 7-ene, and 1, 5-diazabicyclo [4.3 .0] -5-nonene) , other cyclic amines (for example, piperidine and amino pyridine), guanidine, and the like.

Examples of the inorganic basic compound include hydroxides (for example, potassium hydroxide and sodium hydroxide) of ammonia, alkali metals, or alkaline earth metals.

The amount of the basic compound contained in the polishing composition is preferably 0.005% by weight or more, more preferably 0.01% by weight or more, and still more preferably 0.03% by weight or more. A higher polishing removal rate may be realized by an increase in the amount of the basic compound. The amount of the basic compound contained in the polishing composition is preferably 1.0% by weight or less, more preferably 0.5% by weight or less, still more preferably 0.3% by weight or less, and yet still more preferably 0.15% by weight or less from the viewpoint of an improvement of flatness of a substrate.

<Water>

As water comprising the polishing composition disclosed herein, ion exchanged water (deionized water), pure water, ultrapure water, distilled water, and the like can be preferably used. In the water to be used, the total content of transition metal ions is preferably 100 ppb or less, for example, in order to avoid hindering the effects of the other components contained in the polishing composition as much as possible. For example, the purity of water can be increased by operations of removal of impurity ions by ion exchange resin, removal of contaminants through a filter, distillation, and the like.

The polishing composition disclosed herein may further contain organic solvents (lower alcohol, lower ketone, and the like) which may be uniformly mixed with water, as necessary. In usual, it is preferable that 90% by volume or more of the solvent contained in the polishing composition is water and it is more preferable that 95% by volume or more (typically 99 to 100% by volume) thereof is water.

<Chelating agent>

The polishing composition disclosed herein can include a chelating agent as an optional component. The chelating agent suppresses metal impurities contamination of the object to be polished by forming complex ions with metal impurities which may be contained in the polishing composition and capturing the same. The chelating agent may be used alone or in combination of two or more types thereof.

Examples of the chelating agent include aminocarboxylic acid chelating agents and organic phosphonic acid chelating agents. Examples of the aminocarboxylic acid chelating agent include ethylenediaminetetraacetic acid, ethylenediaminetetraacetic acid sodium salt, nitrilotriacetic acid, nitrilotriacetic acid sodium salt, nitrilotriacetic acid ammonium salt, hydroxyethyl ethylene diamine triacetic acid, hydroxyethyl ethylene diamine triacetic acid sodium salt, diethylenetriamine pentaacetic acid, diethylenetriamine pentaacetic acid sodium salt, triethylene tetramine hexaacetic acid, and triethylene tetramine hexaacetic acid sodium salt. Examples of the organic phosphonic acid chelating agent include 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methane hydroxy phosphonic acid, 2-phosphonobutane-1,2-dicarboxylic acid, 1-phosphonobutane-2,3,4-tricarboxylic acid, and $\alpha$-methylphosphono succinic acid. Among the above, the organic phosphonic acid chelating agents are more preferable and, in particular, aminotri(methylenephosphonic acid), ethylenediaminetetrakis(methylenephosphonic acid), and diethylenetriaminepenta(methylenephosphonic acid) are mentioned as preferable chelating agents.

The amount of the chelate contained in the polishing composition is preferably 0.0001% by weight or more, more preferably 0.0005% by weight or more, and still more preferably 0 . 001% by weight or more. The metal contamination of a substrate may be reduced by an increase in the amount of the chelating agent. The amount of the chelate contained in the polishing composition is preferably 0.1% by weight or less, more preferably 0.01% by weight or less, and still more preferably 0.005% by weight or less from the viewpoint of an improvement of the storage stability of the polishing composition.

<Other components>

The polishing composition disclosed herein may further contain known additives which may be used in polishing compositions (typically polishing compositions for use in a polishing process of a silicon wafer), such as a surfactant, an organic acid, an inorganic acid, an antiseptic, and an antifungal agent, as necessary insofar as the effects of the present invention are not remarkably impaired.

The polishing composition disclosed herein can include a surfactant (typically water-soluble organic compounds having a molecular weight of less than $1 \times 10^4$) as optional components. The use of the surfactant may increase the dispersion stability of the polishing composition. The surfactant also has an effect of changing the contact angle by adsorption to interface between each part as with the above-described water-soluble polymer or basic compound. The surfactant may be used alone or in combination of two or more types thereof.

As the surfactant, anionic surfactants or nonionic surfactants may be preferably used. Nonionic surfactants are more preferable from the viewpoint of low foaming property or ease of pH adjustment. Examples of the nonionic surfactant include oxyalkylene polymers (for example, polyethylene glycol, polypropylene glycol, polytetramethylene glycol, and the like), polyoxyalkylene adducts (for example, polyoxyethylene alkyl ether, polyoxyethylene alkyl phenyl ether, polyoxyethylene alkyl amine, polyoxyethylene fatty acid ester, polyoxyethylene glyceryl ether fatty acid ester, and polyoxyethylene sorbitan fatty acid ester), copolymers of a plurality of kinds of oxyalkylenes (diblock type, triblock type, random type, and alternating type), and the like.

The amount of the surfactant contained in the polishing composition is preferably 0.5% by weight or less, more preferably 0.2% by weight or less, and still more preferably 0.1% by weight or less. The polishing composition disclosed herein may be preferably made in an aspect of substantially free of a surfactant.

It is preferable that the polishing composition disclosed herein does not substantially contain an oxidant. This is because, when the oxidant is contained in the polishing composition, the surface of an object to be polished (for example, silicon wafer) is oxidized by the supply of the composition to the object to be polished, so that an oxide layer is generated, which may reduce the polishing removal rate. Specific examples of the oxidant referred to herein include hydrogen peroxide ($H_2O_2$), potassium permanganate, sodium persulfate, ammonium persulfate, sodium dichloroisocyanurate, and the like. The fact that the polishing composition substantially does not contain the oxidant refers to at least intentionally not containing the oxidant. Therefore, polishing compositions inevitably containing a slight amount (For example, the molar concentration of the oxidant in the polishing compositions is 0.0005 mol/L, preferably 0.0001 mol/L, more preferably 0.00001 mol/L or less, and particularly preferably 0.000001 mol/L or less.) of the oxidant originating from raw materials, manufacturing methods, and the like may be included in the concept of the polishing composition substantially not containing the oxidant referred to herein.

<Polishing liquid>

The polishing composition disclosed herein is typically supplied to an object to be polished in the form of a polishing liquid including the polishing composition and is used for polishing the object to be polished. The polishing liquid may be prepared by diluting any one of the polishing compositions disclosed herein (typically, diluting with water), for example. Alternatively, the polishing composition may be used as a polishing liquid as it is. More specifically, the concept of the polishing composition in the art disclosed herein includes both a polishing liquid (working slurry) which is supplied to an object to be polished to be used for polishing the object to be polished and a concentrate (stock solution of the polishing liquid) which is diluted to be used as a polishing liquid. Other examples of the polishing liquid containing the polishing composition disclosed herein may be a polishing liquid obtained by adjusting the pH of the composition.

The pH of the polishing liquid is preferably 8.0 or more, more preferably 9.0 or more, still more preferably 9.5 or more, and yet more preferably 10.0 or more. When the pH of the polishing liquid increases, the polishing removal rate tends to increase. The pH is preferably 12.0 or less, more preferably 11.5 or less, and still more preferably 11.0 or less from the viewpoints of the stability of the abrasives in the polishing liquid and the like. The pH may be preferably applied to the polishing liquid for use in polishing a silicon wafer. The pH of the polishing liquid can be obtained by performing three-point calibration using a standard buffer solution (Phthalic acid salt pH buffer solution, pH: 4.01 (25°C), Neutral phosphoric acid pH buffer solution, pH: 6.86 (25°C) , Carbonate pH buffer solution, pH: 10.01 (25°C)) using a pH meter (for example, glass electrode type hydrogen ion concentration indicator (Model No. F-23) manufactured by Horiba, Ltd.) , putting the glass electrode into the polishing liquid, and then measuring values stabilized after the lapse of 2 minutes or more.

<Concentrate>

The polishing composition disclosed herein may be in a concentrated form (i.e., form of a concentrate of the polishing liquid) before being supplied to an object to be polished. The polishing composition in such a concentrated form is advantageous from the viewpoints of the convenience, cost reduction, and the like in manufacturing, distribution, and storage. The concentration can be 2-fold to 100-fold by volume, for example, and is usually suitably 5-fold to 50-fold. The concentration of the polishing composition according to one preferable aspect is 10-fold to 40-fold.

The polishing composition in the form of the concentrate described above can be used in an aspect where it is diluted at desired timing to prepare a polishing liquid and then the polishing liquid is supplied to an object to be polished. The dilution can be typically performed by adding and mixing the above-described aqueous solvent with the concentrate. When the aqueous solvent is a mixed solvent, only some components among the constituent components of the aqueous solvent may be added for dilution or a mixed solvent containing the constituent components at an amount ratio different from that of the aqueous solvent may be added for dilution. As described below, in a polishing composition of a multi-agent type, a polishing liquid may be prepared by diluting some of the agents, and then mixing the same with another agent or a polishing liquid may be prepared by mixing a plurality of agents, and then diluting the mixture.

The content of the abrasives in the concentrate is preferably 50% by weight or lower, more preferably 45% by weight or lower, and yet more preferably 40% by weight or lower from the viewpoints of the stability (for example, dispersion stability of the abrasives), filterability, and the like of the polishing composition. The content of the abrasives is preferably 1% by weight or higher, more preferably 5% by weight or higher, still more preferably 10% by weight or higher, and yet still more preferably 15% by weight or higher from the viewpoints of the convenience, cost reduction, and the like in manufacturing, distribution, and storage.

The polishing composition disclosed herein may be a one-agent type or may be a multi-agent type including a two-agent type. For example, a configuration may be acceptable in which an A liquid containing some components among the constituent components (typically components other than the aqueous solvent) of the polishing composition and a B liquid containing the remaining components may be mixed to be used for polishing an object to be polished.

<Preparation of polishing composition>

A method for manufacturing the polishing composition disclosed herein is not particularly limited. For example, the respective components contained in the polishing composition may be mixed together using known mixing devices, such as a blade type stirrer, an ultrasonic disperser, and a homomixer. The way of mixing these components is not particularly limited and, for example, all the components may be mixed at once or may be mixed in a suitably selected order.

<Application>

The polishing composition disclosed herein may be applied to polishing objects to be polished having various materials and shapes. The materials of the objects to be polished may be metals, metalloids, or alloys thereof (for example, silicon, aluminum, nickel, tungsten, copper, tantalum, titanium, stainless steel, and germanium), glass-like substances (for example, quartz glass, aluminosilicate glass, and glass-like carbon), ceramic materials (for example, alumina, silica, sapphire, silicon nitride, tantalum nitride, and titanium carbide), compound semiconductor substrate materials (for example, silicon carbide, gallium nitride, gallium arsenide, and the like), resin materials (for example, polyimide resin) , and the like. Objects to be polished may be composed of two or more of the materials among the above. In particular, the polishing composition is preferable for polishing objects to be polished having a surface composed of silicon (for example, silicon materials, such as a silicon single crystal wafer) . The art disclosed herein may be particularly preferably applied to a polishing composition typically which contains only silica particles as the abrasives and which is for the object to be polished composed of a silicon material.
The shape of the object to be polished is not particularly limited. The polishing composition disclosed herein may be preferably applied to polishing objects to be polished having planes, such as a plate shape and a polyhedron shape, or an edge of objects to be polished (for example, polishing a wafer edge), for example.

<Polishing machines

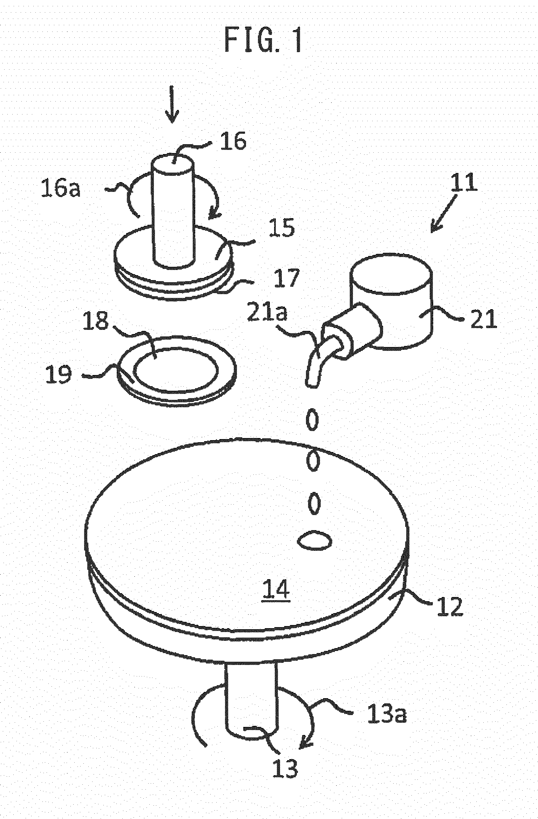

Then, a polishing machine is described. FIG. 1 is a perspective view illustrating a single-side polishing machine according to one embodiment of the present invention. As illustrated in FIG. 1, a single-side polishing machine 11 has a disk-shaped rotary platen 12 to the upper surface of which a polishing pad 14 is stuck. The rotary platen 12 is integrally rotatably provided to a first shaft 13 rotating in the direction indicated by an arrow 13a of FIG. 3. At least one holder of the object to be polished 15 is provided above the rotary platen 12. The holder of the object to be polished 15 is integrally rotatably provided to a second shaft 16 rotating in the direction indicated by an arrow 16a of FIG. 3. To the bottom surface of the holder of the object to be polished 15, a holding plate of the object to be polished 19 having a holding hole of the object to be polished 18 is removably attached through a ceramic plate 17 and a urethane sheet which is not illustrated. The single-side polishing machine 11 may further have a polishing composition supply system 21 and a rinsing composition supply system which is not illustrated. The polishing composition supply system 21 may discharge a polishing liquid through a nozzle 21a and, from the rinsing composition supply system which is not illustrated, a rinsing composition may be discharged through a nozzle which is not illustrated. In that case, the rinsing composition supply system in place of the polishing composition supply system 21 is disposed above the rotary platen 12. After switching the operation conditions of the single-side polishing machine 11 from the setting for polishing to the setting for rinsing, the rinsing composition is discharged from the rinsing composition supply system, and then the rinsing composition is supplied onto a polishing pad 14. Thus, the surface of the object to be polished contacting the polishing pad 14 is rinsed. The rinsing composition may be discharged through the nozzle 21a of the polishing composition supply system 21.
When polishing the object to be polished, the polishing composition supply system 21 is disposed above a rotary platen 12 as illustrated in FIG. 1. The object to be polished is sucked into the holding hole of the object to be polished 18 to be held by the holder of the object to be polished 15. First, the rotation of the holder of the object to be polished 15 and the rotary platen 12 is started, and then the polishing liquid or, depending on the case, the rinsing composition is discharged from the polishing composition supply system 21 to be supplied onto the polishing pad 14. Then, the holder of the object to be polished 15 is moved toward the rotary platen 12 so as to press the object to be polished against the polishing pad 14. Thus, one surface of the object to be polished contacting the polishing pad 14 is polished or rinsed. The polishing pad is not particularly limited and any one of a polyurethane type, a nonwoven fabric type, a suede type, substances containing abrasives, and substances not containing abrasives may be used.
By providing one more disk-shaped rotary platen to which the polishing pad is stuck, a final polishing machine illustrated in FIG. 1 can be utilized as a stock polishing machine polishing both surfaces of an object to be polished. FIG.

2 is a perspective view illustrating a double-side polishing machine according to one embodiment of the present invention.

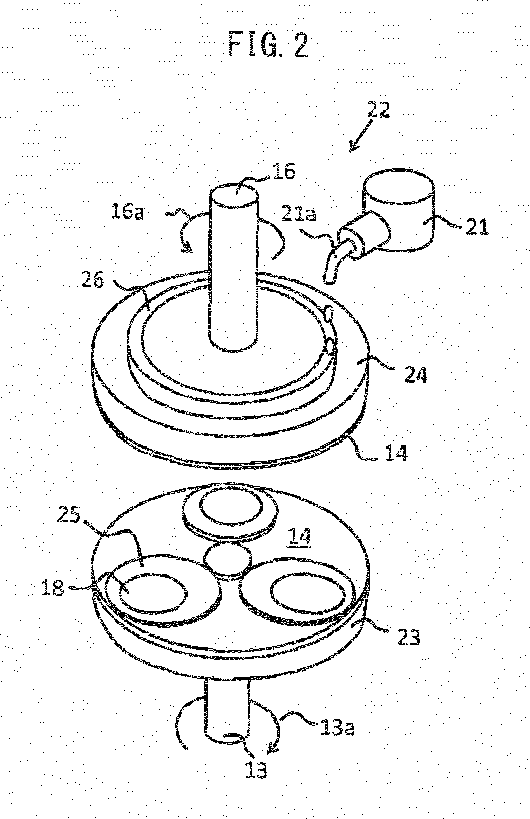

As illustrated in FIG. 2, as one embodiment of the double-side polishing machine, a disk-shaped rotary platen to which a polishing pad is stuck is further provided in the upper portion to be used as an upper rotary platen (upper platen 24) to which the polishing pad 14 is stuck, and the polishing pad 14 stuck to a lower platen 23 and the polishing pad 14 stuck to the upper platen 24 hold the object to be polished held by the holding hole of the object to be polished 18 therebetween. The upper rotary platen has a flow hole (polishing composition supply channel 26) which causes a stock polishing composition or a final polishing composition (preferably stock polishing composition) for a rinsing composition depending on the case) discharged from the polishing composition supply system 21 to flow out to the lower portion.

The upper rotary platen (upper platen 24) and the lower rotary platen (lower platen 23) rotate in opposite directions as indicated by the arrow 13a and the arrow 16a, the stock polishing composition, the final polishing composition, or, depending on the case, the rinsing composition is discharged from the polishing composition supply system 21, and then both the polishing pads 14 rotate while pressing both the surfaces of the object to be polished, whereby both the surfaces of the object to be polished are polished or rinsed.

As illustrated in FIG. 2, the double-side polishing machine 22 does not require the holder of the object to be polished 15 illustrated in FIG. 1 but requires the holding plate of the object to be polished 19 having one holding hole of the object to be polished 18 in place thereof, which is entirely referred to as a holder of the object to be polished or a processing carrier 25. According to the aspect illustrated in FIG. 2, one object to be polished is contained in one holding plate and three holding plates are provided. However, according to another aspect, there is a case where five holding plates each containing one object to be polished are provided or there is a case where three objects to be polished are contained in one holding plate. In the present invention, any machine can be used and known machines can be used as they are or can be used after improved as appropriate without being particularly limited in the number of the holding plates and the number of the objects to be polished held by one holding plate.

In the present invention, the holding tool of an object to be polished refers to the holding plate of the object to be polished 19 in the single-side polishing machine and the processing carrier 25 in the double-side polishing machine.

<Polishing>

The polishing composition disclosed herein may be preferably used as a polishing composition for polishing silicon materials, such as a silicon substrate (for example, a monocrystalline or polycrystalline silicon wafer, particularly a silicon single crystal wafer). Hereinafter, a preferable aspect of a method for polishing an object to be polished using the polishing composition disclosed herein is described.

More specifically, a polishing liquid containing anyone of the polishing compositions disclosed herein is prepared. The preparation of the polishing liquid may include subjecting the polishing composition to operations of concentration adjustment (for example, dilution), pH adjustment, and the like to prepare a polishing liquid. Or, the polishing composition may be used, as it is, as a polishing liquid. In the case of a polishing composition of a multi-agent type, the preparation of the polishing liquid may include mixing the agents, diluting one or a plurality of agents before the mixing, diluting the mixture after the mixing, and the like.

Subsequently, the polishing liquid is supplied to an object to be polished, and then the object to be polished is polished by a conventional method. For example, when performing a stock polishing step (typically double-side polishing step) of the silicon substrate, the silicon substrate passing through a lapping process is set in a common polishing machine, and then the polishing liquid is supplied to the surface to be polished of the silicon substrate through a polishing pad of the polishing machine. Typically, the polishing pad is pressed against the surface to be polished of the silicon substrate to relatively move the same (for example, rotation movement) while continuously supplying the polishing liquid. Thereafter, a further secondary polishing step (typically single-side polishing step) is performed as necessary, finally final polishing is performed and polishing the object to be polished is completed.

The polishing composition disclosed herein may be used in an aspect of being disposed after being used for polishing once (so-called "one-way") or may be repeatedly used in recycle. As an example of a method for using the polishing composition in recycle, a method including collecting the used polishing composition discharged from the polishing machine in a tank, and then supplying the collected polishing composition to the polishing machine again is mentioned. When the polishing composition is used in recycle, the amount of the used polishing composition treated as a waste liquid decreases as compared with a case of using the same in the one-way, and thus the environmental load can be reduced. Moreover, the cost can be reduced by the reduction in the used amount of the polishing composition.

When the polishing composition disclosed herein is used in recycle, new components, components that are reduced during use or components that are desirably increased, may be add to the polishing composition during the use at suitably timing.

In one preferable aspect, the substrate polishing step using the polishing composition is a polishing step on the upstream side relative to the final polishing. In particular, the step is preferably applicable to stock polishing the substrate after subjected to the lapping process. For example, in the double-side polishing step (typically stock polishing step performed using the double-side polishing machine) performed to the substrate passing through the lapping process or in the first step of single-side polishing (typically a first step of secondary polishing) performed to the substrate passing through the double-side polishing step, the polishing compositions disclosed herein may be preferably used. Furthermore, in the stock polishing steps performed using the double-side polishing machine, the polishing compositions disclosed herein may be more preferably used.

<Examples>

Hereinafter, some Examples relating to the present invention are described but it is not intended that the present invention is limited to those described in Examples.

<Preparation of polishing composition>

The following polishing compositions A to G were prepared. The polishing composition A was used in Examples 1, 3, 5, and 7, the polishing composition B was used in Example 2, the polishing composition C was used in Example 4, the polishing composition D was used in Example 6, the polishing composition E was used in Example 8 and Comparative Example 3, the polishing composition F was used in Comparative Example 1, and the polishing composition G was used in Comparative Example 2.

(Polishing composition A)

1.17% by weight of colloidal silica (Average primary particle diameter of 51 nm, Average secondary particle diameter of 101 nm) as abrasives, 0.00024% by weight of polyvinyl pyrrolidone (Weight average molecular weight of 45,000) as a water-soluble polymer, 0.037% by weight of potassium carbonate as a salt, 0.057% by weight of tetramethylammonium hydroxide and 0.0043% by weight of potassium hydroxide as a basic compound, and the balance pure water were mixed to prepare a polishing composition of Example 1. The pH of the polishing composition was 10.5.

(Polishing composition B)

0.29% by weight of colloidal silica (Average primary particle diameter of 35 nm, Average secondary particle diameter of 68 nm) as abrasives, 0.0014% by weight of polyvinyl pyrrolidone (Weight average molecular weight of 45,000) as a water-soluble polymer, 0.15% by weight of potassium carbonate as a salt, 0.14% by weight of tetramethylammonium hydroxide as a basic compound, and the balance pure water were mixed to prepare a polishing composition of Example 2. The pH of the polishing composition was 10.7.

(Polishing composition C)

1.17% by weight of colloidal silica (Average primary particle diameter of 51 nm, Average secondary particle diameter of 101 nm) as abrasives, 0.00024% by weight of polyvinyl pyrrolidone (Weight average molecular weight of 45,000) as a water-soluble polymer, 0.037% by weight of potassium carbonate as a salt, 0.057% by weight of tetramethylammonium hydroxide, 0.0043% by weight of potassium hydroxide, and 0.1% by weight of hydroxyethylcellulose (Weight average molecular weight of 1200000) as a basic compound, and the balance pure water were mixed to prepare a polishing composition of Example 3. The pH of the polishing composition was 10.5.

(Polishing composition D)

1.08% by weight of colloidal silica (Average primary particle diameter of 51 nm, Average secondary particle diameter of 101 nm) as abrasives, 0.00022% by weight of polyvinyl pyrrolidone (Weight average molecular weight of 45,000) as a water-soluble polymer, 0.033% by weight of potassium carbonate as a salt, 0.051% by weight of tetramethylammonium hydroxide, 0.0039% by weight of potassium hydroxide, and 0.01% by weight of hydroxyethylcellulose (Weight average molecular weight of 1200000) as a basic compound, and the balance pure water were mixed to prepare a polishing composition of Example 5. The pH of the polishing composition was 10.5.

(Polishing composition E)

1.17% by weight of colloidal silica (Average primary particle diameter of 51 nm, Average secondary particle diameter of 72 nm) as abrasives, 0.00024% by weight of polyvinyl pyrrolidone (Weight average molecular weight of 45,000) as a water-soluble polymer, 0.037% by weight of potassium carbonate as a salt, 0.057% by weight of tetramethylammonium hydroxide, 0.0043% by weight of potassium hydroxide, and 0.01% by weight of polyethylene glycol (Weight average molecular weight of 300) as a basic compound, and the balance pure water were mixed to prepare a polishing composition of Example 3. The pH of the polishing composition was 10.5.

(Polishing composition F)

0.29% by weight of colloidal silica (Average primary particle diameter of 35 nm, Average secondary particle diameter of 68 nm) as abrasives, 0.063% by weight of tetramethylammonium hydroxide as a basic compound, and the balance pure water were mixed to prepare a polishing composition of Example 2. The pH of the polishing composition was 10.8.

(Polishing composition G)

0.29% by weight of colloidal silica (Average primary particle diameter of 35 nm, Average secondary particle diameter of 68 nm) as abrasives, 0.095% by weight of potassium carbonate as a salt, 0.14% by weight of tetramethylammonium hydroxide as a basic compound, and the balance pure water were mixed to prepare a polishing composition of Example 2. The pH of the polishing composition was 10.7.

<Polishing pad>

As a polishing pad, SUBA800 manufactured by Nitta Haas, Inc. was used in Examples 1, 3, 4, 5, 6, and 8 and MH-S15A manufactured by Nitta Haas, Inc. was used in Examples 2 and 7 and Comparative Examples 1, 2, and 3.

<Holding tool of object to be polished >

As a holding tool of an object to be polished, a processing carrier containing glass epoxy was used in Examples 1, 3, 4, 6, 7, and 8, a processing carrier containing SUS304 was used in Example 2 and Comparative Examples 1, 2, and 3, and a DLC (diamond Like Carbon) coating carrier manufactured by SpeedFam Company Limited., was used in Example 5.

<Measurement of receding contact angle of polishing composition to polishing pad >

The receding contact angle Cp of the polishing composition according to each example to the polishing pad was measured based on the following procedure.

(1P) Dispose a new polishing pad on a dynamic contact angle meter DM-501 manufactured by Kyowa Interface Science Co., LTD.
(2P) Drop 30 $\mu$L of the polishing composition to the polishing pad.
(3P) Incline the polishing pad at a rate of 1°/s after dropping the polishing composition, and then measure the receding contact angle after the lapse of 10 seconds.

The obtained results are shown in Table 1.

<Measurement of receding contact angle of polishing composition to object to be polished>

The receding contact angle Cw of the polishing composition according to each example to an object to be polished was measured based on the following procedure.

(1W) Dispose an object to be polished (300 mm silicon wafer, Conductive type: P type, Crystal orientation <100>, Resistivity of 0.1 $\Omega\cdot$cm or more and less than 100 $\Omega\cdot$cm) which was mirror-finished and from which a native oxide layer was removed beforehand on a dynamic contact angle meter DM-501 manufactured by Kyowa Interface Science Co., LTD.
(2W) Drop 30 $\mu$L of the polishing composition to the object to be polished.
(3W) Incline the object to be polished at a rate of 1°/s after dropping the polishing composition, and then measure the receding contact angle after the lapse of 10 seconds.

The obtained results are shown in Table 1.

<Measurement of receding contact angle of polishing composition to holding tool of object to be polished >

The receding contact angle Cc of the polishing composition according to each example to a holding tool of an object to be polished was measured based on the following procedure.

(1C) Dispose a new holding tool of an object to be polished on a dynamic contact angle meter DM-501 manufactured by Kyowa Interface Science Co., LTD.
(2C) Drop 30 μL of the polishing composition to the holding tool of an object to be polished.
(3C) Incline the holding tool of an object to be polished at a rate of 1°/s after dropping the polishing composition, and then measure the receding contact angle after the lapse of 10 seconds.

The obtained results are shown in Table 1.

<Measurement of dynamic surface tension of polishing composition to polishing pad >

The dynamic surface tension Tp of the polishing composition according to each example to a polishing pad was measured based on the following procedure.

(1p) Cut a new polishing pad into a size of 25 mm × 40 mm.
(2p) Take out the polishing pad, and then immerse the same in the polishing composition for 1 minute.
(3p) Take out the polishing pad, and then immerse the same in a container containing ion exchange water for 1 second.
(4p) Take out the polishing pad, and then spray air thereto until excess water is blown off with an air gun or the like.
(5p) Dispose the polishing pad on a dynamic wettability tester 6200TN manufactured by Rhesca Co., Ltd.
(6p) Immerse 10 mm of the polishing pad in the polishing composition disposed in the dynamic wettability tester beforehand at a rate of 0.2 mm/s, and then hold the same for 2 seconds.
(7p) Pull up the polishing pad at a rate of 0.2 mm/s.
(8p) Measure the advancing surface tension by the above-described test.

The obtained results are shown in Table 2.

<Measurement of dynamic surface tension of polishing composition to object to be polished>

The dynamic surface tension Tw of the polishing composition according to each example to an object to be polished was measured based on the following procedure.

(1w) Cut a new object to be polished into a size of 25 mm × 40 mm.
(2w) Immerse the object to be polished in a chemical solution of ammonia:hydrogen peroxide:ion exchange water = 1:1:30 (volume ratio) for 60 seconds.
(3w) Take out the object to be polished, and then immerse the object to be polished in 5% hydrofluoric acid for 60 seconds.
(4w) Take out the object to be polished, and then immerse the same in the polishing composition for 1 minute.
(5w) Take out the object to be polished, and then immerse the same in a container containing ion exchange water for 1 second.
(5w) Take out the object to be polished, and then spray air thereto until excess water is blown off with an air gun or the like.
(7w) Dispose the object to be polished in a dynamic wettability tester 6200TN manufactured by Rhesca Co., Ltd.
(8w) Immerse 10 mm of the object to be polished in the polishing composition disposed in the dynamic wettability tester beforehand at a rate of 0.2 mm/s, and then hold the same for 2 seconds.
(9w) Pull up the object to be polished at a rate of 0.2 mm/s.
(10w) Measure the advancing surface tension by the above-described test.

The obtained results are shown in Table 2.

<Measurement of dynamic surface tension of polishing composition to holding tool of object to be polished >

The dynamic surface tension Tc of the polishing composition according to each example to a holding tool of an object to be polished was measured based on the following procedure.

(1c) Cut a new holding tool of an object to be polished into a size of 25 mm × 40 mm.

(2c) Immerse the holding tool of an object to be polished in a chemical solution of ammonia:hydrogen peroxide:ion exchange water = 1:1:30 (volume ratio) for 60 seconds.

(3c) Take out the holding tool of an object to be polished, and then immerse the object to be polished in 5% hydrofluoric acid for 60 seconds.

(4c) Take out the holding tool of an object to be polished, and then immerse the same in the polishing composition for 1 minute.

(5c) Take out the holding tool of an object to be polished, and then immerse the same in a container containing ion exchange water for 1 second.

(6c) Take out the holding tool of an object to be polished, and then spray air thereto until excess water is blown off with an air gun or the like.

(7c) Dispose the holding tool of an object to be polished in a dynamic wettability tester 6200TN manufactured by Rhesca Co., Ltd.

(8c) Immerse 10 mm of the holding tool of an object to be polished in the polishing composition disposed in the dynamic wettability tester beforehand at a rate of 0.2 mm/s, and then hold the same for 2 seconds.

(9c) Pull up the holding tool of an object to be polished at a rate of 0.2 mm/s.

(10c) Measure the advancing surface tension by the above-described test.

The obtained results are shown in Table 2.

<Evaluation of global flatness>

A polishing test was performed to a silicon wafer using the polishing composition according to each example, as it was, as a polishing liquid, polishing was performed under the following conditions, and then the global flatness was evaluated with a GBIR value. The GBIR is an index showing a difference between the maximum value and the minimum value of the in-plane thickness of the silicon wafer and showing that the global flatness of a substrate is better when the numerical value is smaller. As the object to be polished, the same one (Thickness of 785 $\mu$m) as that described above was used. The results are shown in Table 1 and Table 2.

[Polishing conditions]

Polishing machine: Double-side polishing machine manufactured by SpeedFam Company Limited., "DSM20B-5P-4D" Polishing pressure: 17.5 kPa
Number of rotations of upper platen: 20 rotations/m (counterclockwise rotation)
Number of rotations of lower platen: 20 rotations/m (clockwise rotation)
Supply rate of polishing liquid: 4.5 L/m (using 100 L of polishing liquid in recycle)
Temperature of polishing liquid: 25°C
Polishing removal: 10 $\mu$m

[Evaluation conditions]

Evaluation device: Substrate flatness meter manufactured by KURODA Precision Industries Ltd., "Nanometre 300TT" type Evaluation parameter: GBIR

[Table 1]

| | Polishing composition | Polishing pad | Holding tool of object to be polished | Contact angle of polishing composition [°] | | | Size relationship of Cp, Cw, and Cc | GBIR [nm] |
|---|---|---|---|---|---|---|---|---|
| | | | | Cp | Cw | Cc | | |
| Ex. 1 | A | SUBA800 | Glass epoxy | 74.8 | 40.1 | 46.8 | Cp > Cc > Cw | 150 |
| Ex. 2 | B | MH-S15A | SUS304 | 20.3 | 60.5 | 37.5 | Cw > Cc > Cp | 120 |
| Comp. Ex. 1 | F | MH-S15A | SUS304 | 68.3 | 58.0 | 48.5 | Cp > Cw > Cc | 420 |
| Comp. Ex. 2 | G | MH-S15A | SUS304 | 41.8 | 49.1 | 41.7 | Cw > Cp > Cc | 380 |

[Table 2]

| | Polishing composition | Polishing pad | Holding tool of object to be polished | Dynamic surface tension of polishing composition [mN] | | | Size relationship of Tp, Tw, and Tc | GBIR [nm] |
|---|---|---|---|---|---|---|---|---|
| | | | | Tp | Tw | Tc | | |
| Ex. 3 | A | SUBA800 | Made of glass epoxy | 3.88 | 2.55 | 1.87 | Tp > Tw > Tc | 250 |
| Ex. 4 | C | SUBA800 | Made of glass epoxy | 3.99 | 3.24 | 1.86 | Tp > Tw > Tc | 105 |
| Ex. 5 | A | SUBA800 | DLC coating | 3.88 | 2.55 | 1.52 | Tp > Tw > Tc | 85 |
| Ex. 6 | D | SUBA800 | Made of glass epoxy | 3.96 | 2.90 | 1.95 | Tp > Tw > Tc | 180 |
| Ex. 7 | A | MH-S15A | Made of glass epoxy | 0.30 | 2.55 | 1.87 | Tw > Tc > Tp | 80 |
| Ex. 8 | E | SUBA800 | Made of glass epoxy | 3.80 | 1.84 | 1.89 | Tp > Tc > Tw | 290 |
| Comp. Ex. 3 | E | MH-S15A | Made of SUS304 | 1.20 | 1.84 | 1.89 | Tc > Tw > Tp | 350 |

EP 3 296 376 B1

As shown in Table 1, the GBIR values showing the global flatness of the substrate (Difference between the maximum thickness and the minimum thickness in the substrate) in Example 1 using the polishing liquid satisfying $Cp \geq Cc \geq Cw$ and Example 2 using the polishing liquid satisfying $Cc \geq Cp$ were clearly better than the GBIR values in Comparative Examples 1 and 2 not satisfying $Cp \geq Cc \geq Cw$ and $Cc \geq Cp$.

As shown in Table 2, the GBIR values showing the global flatness of the substrate in Example 7 using the polishing liquid satisfying $Tw \geq Tc \geq Tp$ and Examples 3 to 6 and 8 using the polishing liquid satisfying $Tp \geq Tc$ were clearly better than the GBIR value in Comparative Example 3 not satisfying $Tw \geq Tc \geq Tp$ and $Tp \geq Tc$.

Although specific embodiments of the present invention are described in detail above, these are merely for illustrations and do not limit the scope of claims.

Reference Signs List

| | |
|---|---|
| 11: | single-side polishing machine |
| 14: | polishing pad |
| 12: | rotary platen |
| 13a: | arrow |
| 13: | first shaft |
| 15: | holder of object to be polished |
| 16a: | arrow |
| 16: | second shaft |
| 17: | ceramic plate |
| 18: | holding hole of object to be polished |
| 19: | holding plate of object to be polished |
| 21: | polishing composition supply system |
| 21a: | nozzle |
| 22: | double-side polishing machine |
| 23: | lower platen |
| 24: | upper platen |
| 25: | processing carrier |
| 26: | polishing composition supply channel |

**Claims**

1.  A method of double-side polishing an object, the method comprising the steps of:

    holding the object to be polished held by a holding hole of the object to be polished of a holding tool of the object to be polished between a polishing pad stuck to a lower rotary platen and a polishing pad stuck to an upper rotary platen;
    discharging a polishing composition; and
    rotating the polishing pads while pressing both the surfaces of the object to be polished, wherein the object to be polished is a silicon wafer,
    **characterized in that**:

    the polishing composition comprises abrasives, a water-soluble polymer and a salt,
    wherein the average primary particle diameter of the abrasives is 30 nm or larger, the water-soluble polymer is any one of a cellulose derivative, a starch derivative, a polymer containing an oxyalkylene unit, a polymer containing a nitrogen atom, or a vinylalcohol polymer, the salt comprises potassium carbonate; and
    the method satisfying either the following formula (I) or (II),
    wherein fitting of the polishing composition to the polishing pad is defined as Wp,
    fitting of the polishing composition to the object to be polished is defined as Ww, and
    fitting of the polishing composition to the holding tool of the object to be polished is defined as Wc:

$$Wp \geq Wc \quad (I)$$

$$Ww \geq Wc \geq Wp \quad (II).$$

**2.** The method according to claim 1 satisfying either the following formula (III) or (IV), wherein a receding contact angle of the polishing composition to the polishing pad is defined as Cp, a receding contact angle of the polishing composition to the object to be polished is defined as Cw, and a receding contact angle of the polishing composition to the holding tool of the object to be polished is defined as Cc:

$$Cc \geq Cp \quad (III)$$

$$Cp \geq Cc \geq Cw \quad (IV),$$

said Cp, Cw and Cc being determined as described in the specification.

**3.** The method according to claim 1 satisfying either the following formula (V) or (VI), wherein a dynamic surface tension of the polishing composition to the polishing pad is defined as Tp, a dynamic surface tension of the polishing composition to the object to be polished is defined as Tw, and a dynamic surface tension of the polishing composition to the holding tool of the object to be polished is defined as Tc:

$$Tp \geq Tc \quad (V)$$

$$Tw \geq Tc \geq Tp \quad (VI),$$

said Tp, Tw and Tc being determined as described in the specification.

**Patentansprüche**

**1.** Verfahren zum beidseitigen Polieren eines Objekts, wobei das Verfahren die Schritte umfasst:

Halten des zu polierenden Objekts, gehalten durch eine Halteöffnung des zu polierenden Objekts eines Haltewerkzeugs des zu polierenden Objekts, zwischen einem Polierpad, befestigt an einer unteren Drehplatte, und einem Polierpad, befestigt an einer oberen Drehplatte;
Austragen einer Polierzusammensetzung; und
Drehen der Polierpads während des Pressens beider Oberflächen des zu polierenden Objekts, wobei das zu polierende Objekt ein Siliziumwafer ist,
**dadurch gekennzeichnet, dass**
die Polierzusammensetzung Schleifmittel, ein wasserlösliches Polymer und ein Salz umfasst,
wobei der durchschnittliche Primärteilchendurchmesser der Schleifmittel 30 nm oder mehr ist, das wasserlösliche Polymer irgendeines eines Cellulosederivats, eines Stärkederivats, eines Polymers, enthaltend eine Oxyalkyleneinheit, eines Polymers, enthaltend ein Stickstoffatom, oder ein Vinylalkoholpolymer ist, das Salz Kaliumcarbonat umfasst; und
wobei das Verfahren entweder die folgende Formel (I) oder (II) erfüllt,
wobei das Anpassen der Polierzusammensetzung an das Polierpad als Wp definiert ist,
das Anpassen der Polierzusammensetzung an den zu polierenden Gegenstand als Ww definiert ist, und
das Anpassen der Polierzusammensetzung an das Haltewerkzeug des zu polierenden Objekts als Wc definiert ist:

$$Wp \geq Wc \quad (I)$$

$$Ww \geq Wc \geq Wp \quad (II).$$

**2.** Das Verfahren nach Anspruch 1, erfüllend entweder die folgende Formel (III) oder (IV), wobei ein rückläufiger Kontaktwinkel der Polierzusammensetzung mit dem Polierpad als Cp definiert ist, ein rückläufiger Kontaktwinkel der Polierzusammensetzung mit dem zu polierenden Objekt als Cw definiert ist, und ein rückläufiger Kontaktwinkel der Polierzusammensetzung mit dem Haltewerkzeug des zu polierenden Objekts als Cc definiert ist:

$$Cc \geq Cp \quad (III)$$

$$Cp \geq Cc \geq Cw \quad (IV),$$

wobei besagte Cp, Cw und Cc wie in der Spezifikation beschrieben bestimmt werden.

**3.** Das Verfahren nach Anspruch 1, erfüllend entweder die folgende Formel (V) oder (VI), wobei eine dynamische Oberflächenspannung der Polierzusammensetzung an dem Polierpad als Tp definiert ist, eine dynamische Oberflächenspannung der Polierzusammensetzung an dem zu polierenden Objekt als Tw definiert ist, und eine dynamische Oberflächenspannung der Polierzusammensetzung an dem Haltewerkzeug des zu polierenden Objekts als Tc definiert ist:

$$Tp \geq Tc \quad (V)$$

$$Tw \geq Tc \geq Tp \quad (VI),$$

wobei besagte Tp, Tw und Tc wie in der Spezifikation beschrieben bestimmt werden.

## Revendications

**1.** Procédé de polissage de deux côtés d'un objet, le procédé comprenant les étapes consistant à :

maintenir l'objet à polir maintenu par un trou de maintien de l'objet à polir d'un outil de maintien de l'objet à polir entre un tampon de polissage collé sur un plateau rotatif inférieur et un tampon de polissage collé sur un plateau rotatif supérieur ;
débiter une composition de polissage ; et
faire tourner les tampons de polissage tout en pressant les deux surfaces de l'objet à polir, l'objet à polir étant une tranche de silicium,
**caractérisé en ce que**
la composition de polissage comprend des abrasifs, un polymère hydrosoluble et un sel,
le diamètre moyen de particule primaire des abrasifs est supérieur ou égal à 30 nm, le polymère hydrosoluble est l'un quelconque parmi un dérivé de cellulose, un dérivé d'amidon, un polymère contenant un motif oxyalkylène, un polymère contenant un atome d'azote, ou un polymère d'alcool vinylique, le sel comprend du carbonate de potassium ; et
le procédé satisfait à la formule (I) ou (II) suivante,
le degré d'adhérence de la composition de polissage au tampon de polissage étant défini en tant que Wp, le degré d'adhérence de la composition de polissage à l'objet à polir étant défini en tant que Ww, et le degré d'adhérence de la composition de polissage à l'outil de maintien de l'objet à polir étant défini en tant que Wc :

$$Wp \geq Wc \qquad (I)$$

$$Ww \geq Wc \geq Wp \qquad (II)$$

**2.** Procédé selon la revendication 1 satisfaisant à la formule (III) ou (IV) suivante, un angle de mouillage sortant de la composition de polissage sur le tampon de polissage étant défini en tant que Cp, un angle de mouillage sortant de la composition de polissage sur l'objet à polir étant défini en tant que Cw, et un angle de mouillage sortant de la composition de polissage sur l'outil de maintien de l'objet à polir étant défini en tant que Cc :

$$Cc \geq Cp \qquad\qquad\qquad (III)$$

$$Cp \geq Cc \geq Cw \qquad\qquad\qquad (IV)$$

lesdits Cp, Cw et Cc étant déterminés comme détaillé dans la description.

3. Procédé selon la revendication 1 satisfaisant à la formule (V) ou (VI) suivante, une tension superficielle dynamique de la composition de polissage sur le tampon de polissage étant définie en tant que Tp, une tension superficielle dynamique de la composition de polissage sur l'objet à polir étant définie en tant que Tw, et une tension superficielle dynamique de la composition de polissage sur l'outil de maintien de l'objet à polir étant définie en tant que Tc :

$$Tp \geq Tc \qquad\qquad\qquad (V)$$

$$Tw \geq Tc \geq Tp \qquad\qquad\qquad (VI),$$

lesdites Tp, Tw et Tc étant déterminées comme détaillé dans la description.

# FIG. 1

# FIG. 2

**REFERENCES CITED IN THE DESCRIPTION**

**Patent documents cited in the description**

- US 2015060400 A1
- JP 2005268667 A
- WO 201263757 A
- JP 2014041978 A
- WO 2004100242 A